# EUROPEAN PATENT APPLICATION

(11) **EP 4 614 261 A1**
(43) Date of publication of application: **10.09.2025**
(21) Application number: 25160573.9
(22) Date of filing: 27.02.2025
(51) Int. Cl.: G05B 19/418, G05B 23/02

(54) **SYSTEMS AND METHODS FOR DERIVING CAUSAL RELATIONSHIPS FROM PROGRAM CODE**

(30) Priority: 06.03.2024 US 202418597268
(71) Applicant: Rockwell Automation Technologies, Inc., Mayfield Heights, OH 44124 (US)
(72) Inventor: Spaner, Michael A., Mayfield Heights, OH, 44124 (US); Ghafoor, Salma, Mayfield Heights, OH, 44124 (US)
(74) Representative: Grünecker Patent- und Rechtsanwälte PartG mbB

(57) **Abstract**

A system for providing causal graph relationships for industrial automation systems. The system receives a first input indicative of a selection of a design artifact associated with an industrial automation system having one or more industrial automation devices, where the design artifact defines an industrial automation project configured to control operations of the one or more industrial automation devices. In response to the first input, the system parses the design artifact to identify causal relationships between the one or more industrial automation devices, stores data indicative of the identified causal relationships in a database, and generates causal graphs based on the stored data. The system receives a second input indicative of a request to generate a custom view of the industrial automation system, and generates a custom view of the industrial automation system in response to the second input, where the custom view includes the causal graphs.

## Description

### BACKGROUND

The present disclosure relates generally to causality and root cause analysis for industrial automation systems. More specifically, the present disclosure relates to techniques for providing causal graph relationships for industrial automation systems.

This section is intended to introduce the reader to various aspects of art that may be related to various aspects of the present techniques, which are described and/or claimed below. This discussion is believed to be helpful in providing the reader with background information to facilitate a better understanding of the various aspects of the present disclosure. Accordingly, it should be understood that these statements are to be read in this light, and not as admissions of prior art.

It may be challenging to identify causal relationships in industrial automation systems (e.g., identifying a root cause of an event, alarm, etc.). Factors such as confounding variables, complex causal relationships, lack of experimental control, complexity and non-linearity, hidden variables, and randomness may cause challenges in determining causal relationships. For industrial automation systems, causal relationships may be used to determine the causes of anomalies, which may reflect security breaches and unauthorized control modifications. Known causal relationships may then be used to address and correct the underlying causes of the anomalies. Traditionally, historical data has been used to determine the probable causes of industrial automation system anomalies, without certainty of the root cause or causes. Consequently, operators of industrial automation systems may have to try multiple suggested remedial actions before successfully resolving the issue. Accordingly, it may be desirable to develop improved techniques for identifying root causes within complex industrial automation systems.

### BRIEF DESCRIPTION

A summary of certain embodiments disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects that may not be set forth below.

In certain embodiments, a system for providing causal graph relationships for an industrial automation system with one or more industrial automation devices may receive a first input indicative of a selection of a design artifact associated with the industrial automation system, where the design artifact defines an industrial automation project configured to control operations of the one or more industrial automation devices. In response to the first input, the system may parse the design artifact to identify causal relationships between the one or more industrial automation devices, store data indicative of the identified causal relationships in a database, and generate one or more causal graphs based on the stored data. The system may receive a second input indicative of a request to generate a custom view of the industrial automation system, and may generate a custom view of the industrial automation system in response to the second input, where the custom view includes the one or more causal graphs.

In another embodiment, a method for providing causal graph relationships for an industrial automation system with one or more industrial automation devices may include receiving a first input indicative of a selection of a design artifact from a plurality of design artifacts associated with the industrial automation system, where each design artifact of the plurality design artifacts defines an industrial automation project configured to control the industrial automation devices to perform an industrial automation process. In response to receiving the first input, the method may include parsing the selected design artifact, identifying input/output relationships between the one or more industrial automation devices based on the parsed design artifact, and generating one or more causal graphs based on the identified input/output relationships. Additionally, the method may include receiving a second input indicative of a request to generate a custom view of the industrial automation system, and in response, generating the custom view of the industrial automation system, where the custom view includes the one or more causal graphs. Further, the method may include presenting the custom view within a graphical user interface (GUI).

In another embodiment, a non-transitory, tangible, computer readable medium includes instructions for providing causal graph relationships for an industrial automation system with one or more industrial automation devices that, when executed by processing circuitry, causes the processing circuitry to perform operations including receiving a first input indicative of a selection of a design artifact from a plurality of design artifacts associated with the industrial automation system, where each design artifact of the plurality design artifacts defines an industrial automation project to control the one or more industrial automation devices to perform an industrial automation process. The operations include parsing the design artifact in response to receiving the first input, identifying one or more causal relationships between the one or more industrial automation devices based on the parsed design artifact, storing data indicative of the identified causal relationships in a database, and generating one or more causal graphs based on the stored data, where the causal graphs include a visual representation of the input/output relationships between the one or more industrial automation devices. In response to receiving a second input indicative of a request to generate a custom view of the industrial automation system, the operations include generating the custom view of the industrial automation system and presenting the custom view within a graphical user interface (GUI) via an electronic display, where the custom view includes the one or more causal graphs.

### BRIEF DESCRIPTION OF THE DRAWINGS

These and other features, aspects, and advantages of the present disclosure will become better understood when the following detailed description is read with reference to the accompanying drawings in which like characters represent like parts throughout the drawings, wherein:
FIG. 1 is a schematic view of an operation technology (OT) environment, in accordance with an embodiment;
FIG. 2 is a block diagram of example components that could be used in the industrial automation system of FIG. 1, in accordance with an embodiment;
FIG. 3 is a perspective view of an industrial automation system as an example of the OT environment of FIG. 1, in accordance with an embodiment;
FIG. 4 is a schematic view of a programmable logic controller (PLC) ladder logic code and corresponding causal graph, in accordance with an embodiment;
FIG. 5 is a block diagram of a process for capturing causal relationships in context, in accordance with aspects of the present disclosure;
FIG. 6 is a block diagram of a process for extracting causal graph data from a design artifact using the process of FIG. 5, in accordance with aspects of the present disclosure;
FIG. 7 is a flow chart of a process for generating custom views of the industrial automation system of FIG. 1 using causal relationships captured according to the process of FIG. 5, in accordance with aspects of the present disclosure; and
FIG. 8 is a flow chart of a process for updating the custom views of FIG. 7, in accordance with aspects of the present disclosure.

### DETAILED DESCRIPTION

One or more specific embodiments of the present disclosure will be described below. In an effort to provide a concise description of these embodiments, all features of an actual implementation may not be described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

When introducing elements of various embodiments of the present disclosure, the articles "a," "an," "the," and "said" are intended to mean that there are one or more of the elements. The terms "comprising," "including," and "having" are intended to be inclusive and mean that there may be additional elements other than the listed elements. Any examples of operating parameters and/or environmental conditions are not exclusive of other parameters/conditions of the disclosed embodiments.

As used herein, the term "computing system" refers to an electronic computing device such as, but not limited to, a single computer, virtual machine, virtual container, host, server, edge device, laptop, tablet, and/or mobile device, or to a plurality of electronic computing devices working together to perform the function described as being performed on or by the computing system. As used herein, the term "medium" refers to one or more non-transitory, computer-readable physical media that together store the contents described as being stored thereon. Embodiments may include nonvolatile secondary storage, read-only memory (ROM), and/or random-access memory (RAM). As used herein, the term "application" refers to one or more computing modules, programs, processes, workloads, threads and/or a set of computing instructions executed by a computing system. Example embodiments of an application include software modules, software objects, software instances and/or other types of executable code.

The present patent application is directed to techniques for providing causal graph relationships for industrial systems by extracting and deriving causal relationships directly from the design source (e.g., control code, project code files, device configurations, machine builder files, etc.).

Industrial automation systems are often deterministic, meaning the logic controlling the system and defining the input/output relationships between industrial automation devices is embedded in the design source code, such as programmable logic controller (PLC) ladder logic and intelligent device control logic. The disclosed techniques leverage the deterministic nature of industrial automation systems to parse PLC code, piping and instrumentation diagram (P&ID) digital designs, digital twin models, Intelligent Device code, etc. and generate causal graph data. The causal graph data may be extracted from an authoring tool used to design the industrial automation system and/or by parsing existing representations of the industrial automation system. For example, annotated data transmissions of state from HMI/gateway applications may be synthesized, analyzed, and aggregated to leverage causal insights. By extracting the causal relationships directly from the engineering artifacts, this method may provide concise descriptions of the causal relationships, as only relevant causal data is illustrated and presented to the user.

The causal graph data may be used to provide a custom system view to the user, which may be leveraged for performing root cause analysis and other functions. The approach may be applied to hierarchical, interdependent systems and may provide distributed control system (DCS), plant, and fleet views to the user. The custom views may include living causal graphs that update to reflect in real-time changes to the logic controlling the industrial automation system. Accordingly, the disclosed method differs from traditional formal and static analysis of PLC code, as it allows for dynamic updates, as well as, online and offline data analysis at the on-premise edge and in the cloud. The user may use detected anomalies and modifications in the causal graphs to detect security breaches and unauthorized control modifications.

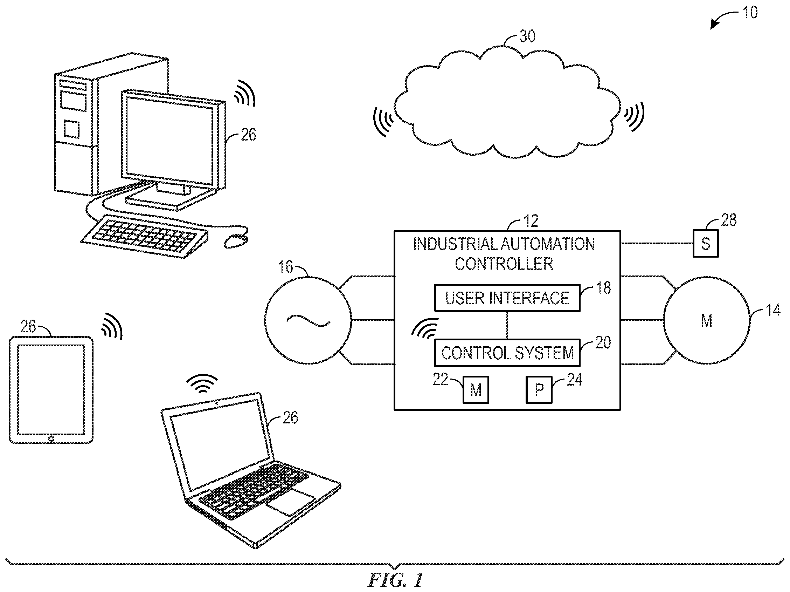

By way of introduction, FIG. 1 is a schematic view of an example operation technology (OT) environment 10 in which the embodiments described herein may be implemented. As shown, the OT environment 10 is an industrial automation system that includes a controller 12 and an actuator 14 (e.g., a motor). The OT environment 10 may also include, or be coupled to, a power source 16. The power source 16 may include a generator, an external power grid, a battery, or some other source of power. The controller 12 may be a stand-alone control unit that controls multiple industrial automation components (e.g., a plurality of motors 14), a controller 12 that controls the operation of a single automation component (e.g., motor 14), or a subcomponent within a larger OT environment 10. In the instant embodiment, the controller 12 includes a user interface 18, such as a human machine interface (HMI), and a control system 20, which may include a memory 22 and a processor 24. The controller 12 may include a cabinet or some other enclosure for housing various components of the OT environment 10, such as a motor starter, a disconnect switch, etc.

The control system 20 may be programmed (e.g., via computer readable code or instructions stored on the memory 22, such as a non-transitory computer readable medium, and executable by the processor 24) to provide signals for controlling the motor 14. In certain embodiments, the control system 20 may be programmed according to a specific configuration desired for a particular application. For example, the control system 20 may be programmed to respond to external inputs, such as reference signals, alarms, command/status signals, etc. The external inputs may originate from one or more relays or other electronic devices. The programming of the control system 20 may be accomplished through software or firmware code that may be loaded onto the internal memory 22 of the control system 20 (e.g., via a locally or remotely located computing device 26) or programmed via the user interface 18 of the controller 12. The control system 20 may respond to a set of operating parameters. The settings of the various operating parameters may determine the operating characteristics of the controller 12. For example, various operating parameters may determine the speed or torque of the motor 14 or may determine how the controller 12 responds to the various external inputs. As such, the operating parameters may be used to map control variables within the controller 12 or to control other devices communicatively coupled to the controller 12. These variables may include, for example, speed presets, feedback types and values, computational gains and variables, algorithm adjustments, status and feedback variables, programmable logic controller (PLC) control programming, and the like.

In some embodiments, the controller 12 may be communicatively coupled to one or more sensors 28 for detecting operating temperatures, voltages, currents, pressures, flow rates, and other measurable variables associated with the OT environment 10. With feedback data from the sensors 28, the control system 20 may keep detailed track of the various conditions under which the OT environment 10 may be operating. For example, the feedback data may include conditions such as actual motor speed, voltage, frequency, power quality, alarm conditions, etc. In some embodiments, the feedback data may be communicated back to the computing device 26 for additional analysis.

The computing device 26 may be communicatively coupled to the controller 12 via a wired or wireless connection. The computing device 26 may receive inputs from a user defining an industrial automation project using a native application running on the computing device 26 or using a website accessible via a browser application, a software application, or the like. The user may define the industrial automation project by writing code, interacting with a visual programming interface, inputting or selecting values via a graphical user interface, or providing some other inputs. The user may use licensed software and/or subscription services to create, analyze, and otherwise develop the project. The computing device 26 may send a project to the controller 12 for execution. Execution of the industrial automation project causes the controller 12 to control components (e.g., motor 14) within the OT environment 10 through performance of one or more tasks and/or processes. In some applications, the controller 12 may be communicatively positioned in a private network and/or behind a firewall, such that the controller 12 does not have communication access outside a local network and is not in communication with any devices outside the firewall, other than the computing device 26. The controller 12 may collect feedback data during execution of the project, and the feedback data may be provided back to the computing device 26 for analysis. Feedback data may include, for example, one or more execution times, one or more alerts, one or more error messages, one or more alarm conditions, one or more temperatures, one or more pressures, one or more flow rates, one or more motor speeds, one or more voltages, one or more frequencies, and so forth. The project may be updated via the computing device 26 based on the analysis of the feedback data.

The computing device 26 may be communicatively coupled to a cloud server 30 or remote server via the internet, or some other network. In one embodiment, the cloud server 30 may be operated by the manufacturer of the controller 12, a software provider, a seller of the controller 12, a service provider, operator of the controller 12, owner of the controller 12, etc. The cloud server 30 may be used to help customers create and/or modify projects, to help troubleshoot any problems that may arise with the controller 12, develop policies, or to provide other services (e.g., project analysis, enabling, restricting capabilities of the controller 12, data analysis, controller firmware updates, etc.). The remote/cloud server 30 may be one or more servers operated by the manufacturer, software provider, seller, service provider, operator, or owner of the controller 12. The remote/cloud server 30 may be disposed at a facility owned and/or operated by the manufacturer, software provider, seller, service provider, operator, or owner of the controller 12. In other embodiments, the remote/cloud server 30 may be disposed in a datacenter in which the manufacturer, software provider, seller, service provider, operator, or owner of the controller 12 owns or rents server space. In further embodiments, the remote/cloud server 30 may include multiple servers operating in one or more data center to provide a cloud computing environment.

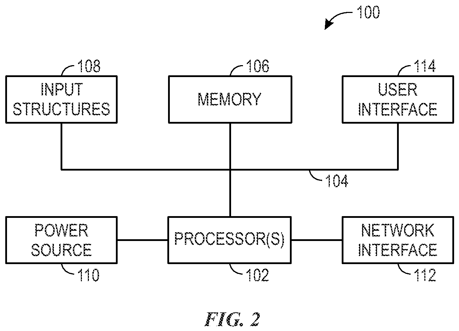

FIG. 2 illustrates a block diagram of example components of a computing device 100 that could be used as the computing device 26, the cloud/remote server 30, the controller 12, or some other device provided by the present disclosure. As used herein, the computing device 100 may be implemented as one or more computing systems including laptop, notebook, desktop, tablet, HMI, or workstation computers, as well as server type devices or portable, communication type devices, such as cellular telephones and/or other suitable computing devices.

As illustrated, the computing device 100 may include various hardware components, such as one or more processors 102, one or more busses 104, memory 106, input structures 108, a power source 110, a network interface 112, a user interface 114, and/or other computer components useful in performing the functions described herein.

The one or more processors 102 may include, in certain implementations, microprocessors configured to execute instructions stored in the memory 106 or other accessible locations. Alternatively, the one or more processors 102 may be implemented as application-specific integrated circuits (ASICs), field-programmable gate arrays (FPGAs), and/or other devices designed to perform functions discussed herein in a dedicated manner. As will be appreciated, multiple processors 102 or processing components may be used to perform functions discussed herein in a distributed or parallel manner.

The memory 106 may encompass any tangible, non-transitory medium for storing data or executable routines. Although shown for convenience as a single block in FIG. 2, the memory 106 may encompass various discrete media in the same or different physical locations. The one or more processors 102 may access data in the memory 106 via one or more busses 104.

The input structures 108 may allow a user to input data and/or commands to the device 100 and may include mice, touchpads, touchscreens, keyboards, controllers, and so forth. The power source 110 can be any suitable source for providing power to the various components of the computing device 100, including line and battery power. In the depicted example, the device 100 includes a network interface 112. Such a network interface 112 may allow communication with other devices on a network using one or more communication protocols. In the depicted example, the device 100 includes a user interface 114, such as a display that may display images or data provided by the one or more processors 102. The user interface 114 may include, for example, a monitor, a display, and so forth. As will be appreciated, in a real-world context a processor-based system, such as the computing device 100 of FIG. 2, may be employed to implement some or all of the present approach, such as performing the functions of the controller, the computing device 26, and/or the cloud/remote server 30 shown in FIG. 1, as well as other memory-containing devices.

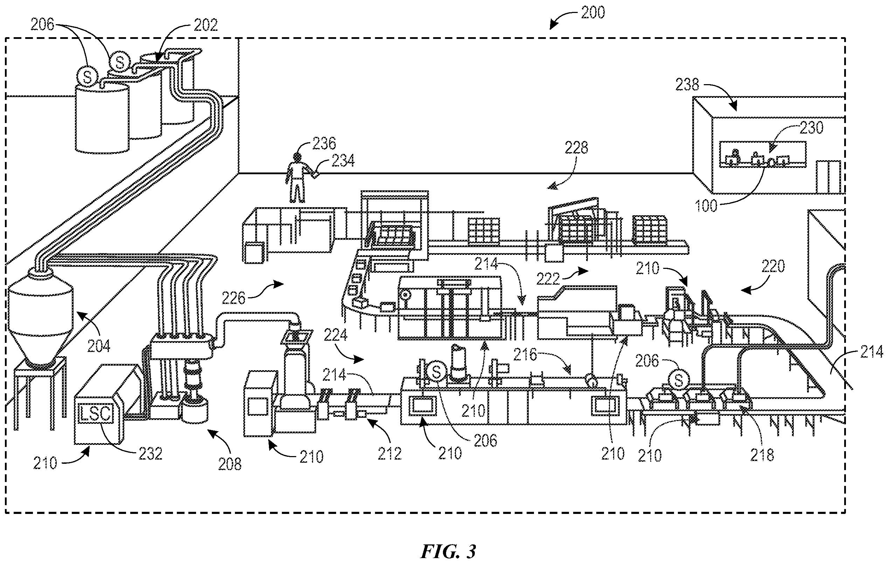

FIG. 3 is a perspective view of an example industrial automation system 200 employed by a food manufacturer. It should be noted that although the example industrial automation system 200 of FIG. 3 is directed at a food manufacturer, the present embodiments described herein may be employed within any suitable industry, such as automotive, cosmetics, chemical manufacturing/processing, mining, hydrocarbon production, manufacturing, and the like. The following brief description of the example industrial automation system 200 employed by the food manufacturer is provided herein to help facilitate a more comprehensive understanding of the OT environment to which the techniques described herein may be applied. As such, the embodiments described herein should not be limited to be applied to the example depicted in FIG. 3.

Referring now to FIG. 3, the example industrial automation system 200 for a food manufacturer may include any number of machines, such as silos 202 and tanks 204. The silos 202 and the tanks 204 may store different types of raw material, such as grains, salt, yeast, sweeteners, flavoring agents, coloring agents, vitamins, minerals, and preservatives. In some embodiments, sensors 206 may be positioned within or around the silos 202, the tanks 204, or other suitable locations within the industrial automation system 200 to measure certain properties, such as temperature, mass, volume, pressure humidity, and the like.

The raw materials may be provided to a mixer 208, which may mix the raw materials together according to a specified ratio. The mixer 208 and other machines in the industrial automation system 200 may employ certain industrial automation devices 210 to control the operations of the mixer 208 and other machines. The industrial automation devices 210 may include controllers (e.g., industrial automation controller 12), input/output (I/O) modules, motor control centers (e.g., control system 20), motors (e.g., actuator 14), human-machine interfaces (e.g., user interface 18), operator interfaces, contactors, starters, sensors (e.g., sensor 28, sensors 206), conveyors, drives, relays, protection devices, switchgear, compressors, firewall, network switches (e.g., Ethernet switches, modular-managed, fixed-managed, service-router, industrial, unmanaged, etc.) and the like.

The mixer 208 may provide a mixed compound to a depositor 212, which may deposit a certain amount of the mixed compound onto conveyor 214. The depositor 212 may deposit the mixed compound on the conveyor 214 according to a shape and amount that may be specified to a control system for the depositor 212. The conveyor 214 may be any suitable conveyor system that transports items to various types of machinery across the industrial automation system 200. For example, the conveyor 214 may transport deposited material from the depositor 212 to an oven 216, which may bake the deposited material. The baked material may be transported to a cooling tunnel 218 to cool the baked material, such that the cooled material may be transported to a tray loader 220 via the conveyor 214. The tray loader 220 may include machinery that receives a certain amount of the cooled material for packaging. By way of example, the tray loader 220 may receive 25 ounces of the cooled material, which may correspond to an amount of cereal provided in a cereal box.

A tray wrapper 222 may receive a collected amount of cooled material from the tray loader 220 into a bag, which may be sealed. The tray wrapper 222 may receive the collected amount of cooled material in a bag and seal the bag using appropriate machinery. The conveyor 214 may transport the bagged material to case packer 224, which may package the bagged material into a box. The boxes may be transported to a palletizer 226, which may stack a certain number of boxes on a pallet that may be lifted using a forklift or the like. The stacked boxes may then be transported to a shrink wrapper 228, which may wrap the stacked boxes with shrink-wrap to keep the stacked boxes together while on the pallet. The shrink-wrapped boxes may then be transported to storage or the like via a forklift or other suitable transport vehicle.

To perform the operations of each of the devices in the example industrial automation system 200, the industrial automation devices 210 may be used to provide power to the machinery used to perform certain tasks, provide protection to the machinery from electrical surges, prevent injuries from occurring with human operators in the industrial automation system 200, monitor the operations of the respective device, communicate data regarding the respective device to a supervisory control system 230, and the like. In some embodiments, each industrial automation device 210 or a group of industrial automation devices 20 may be controlled using a local control system 232. The local control system 232 may include receive data regarding the operation of the respective industrial automation device 210, other industrial automation devices 210, user inputs, and other suitable inputs to control the operations of the respective industrial automation devices 210.

An operator device 234 is an example of the computing device 26 that enables an operator 236 to access or interface with other industrial automation devices 210 and/or computing devices. For example, the operator device 234 may include the processor 102, busses 104, memory 106, input structures 108, power source 110, network interface 112, and user interface 114.

Collectively, any or all of the machines (e.g., mixer 208, palletizer 226), the industrial automation devices 210, the computing devices 26, the cloud server 30, the supervisory control system 230, and any other elements of FIG. 3 may constitute the OT environment. These elements may communicate across the OT environment via a network (e.g., a local area network (LAN)). In some embodiments, the network may be managed from a network operations center 238 (NOC). The NOC 238 is a centralized location from which a network administrator may monitor and manage the network. For example, the NOC 238 may include a central computing system which executes a network security system, monitors traffic into and out of the network, maintains databases, and manages security policies. As shown, the NOC 238 is local to the industrial automation system 200, but in other embodiments, the NOC 238 may be located at a remote location.

During operation of the industrial automation system 200, an anomaly may occur for which an operator may wish to identify the root cause. However, identifying the root cause may be challenging. Factors such as confounding variables, complex causal relationships, lack of experimental control, complexity and non-linearity, hidden variables, and randomness may cause challenges in determining causal relationships. Accordingly, the presently disclosed techniques are directed towards identifying complex causal relationships in the OT environment. For example, the depositor 212 may deposit an unexpected amount and/or shape of mixed compound onto the conveyor 214. This unexpected event may occur due to an unauthorized control modification to the control system for the depositor 212 (e.g., an unauthorized command increasing or decreasing in the amount of mixed compound deposited, an unauthorized command changing the shape of raw material deposited, etc.), an unauthorized control modification to the control system for the mixer 208 (e.g., an unauthorized command altering the ratio of raw materials, etc.), and the like. Accordingly, the present disclosure seeks to address factors such as confounding variables, complex causal relationships, lack of experimental control, complexity, non-linearity, hidden variables, and randomness that may cause challenges in determining causal relationships within OT environments. Specifically, the present disclosure is directed towards a system and method for providing causal graph relationships for complex industrial systems by extracting and deriving causal relationships directly from design sources defining the operations of industrial devices within the respective industrial systems. The design sources may include control code, project code files, device configurations, machine builder files, programmable logic controller (PLC) ladder logic, intelligent device control logic, and the like.

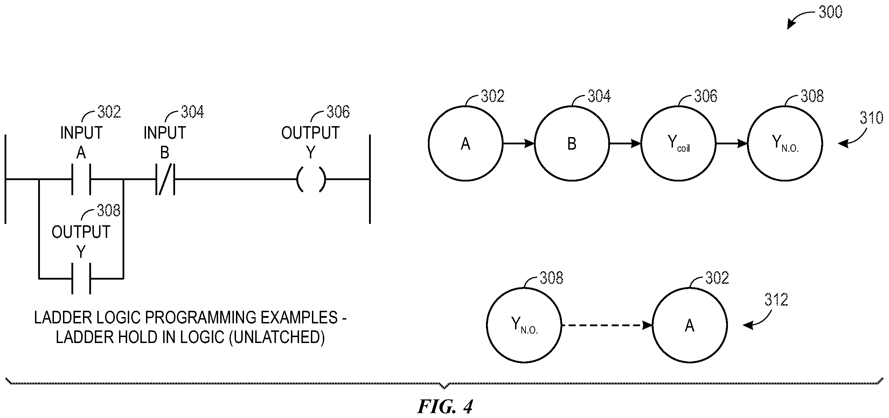

With the foregoing in mind, FIG. 4 illustrates a schematic view of a programmable logic controller (PLC) ladder logic code 300 and corresponding causal graph 310 and causal subgraph 312, in accordance with embodiments described herein. Although the following description of the system and method are described as generating causal graphs 310 and 312 by extracting and deriving causal relationships directly from a simple PLC ladder logic code 300, which represents a particular embodiment, it should be noted that the system and method may generate causal graphs by parsing different PLC code (i.e., containing multiple ladder logic expressions), P&ID digital designs, digital twin models, Intelligent Device code, as well as any other types of design artifacts used to design, configure, or update the OT environment. Moreover, although the following description of generating the causal graphs 310 and 312 from the PLC code 300 is described as being performed by the computing device 26, it should be noted that the causal graphs 310 and 312 may be generating by any suitable computing device (e.g., operator device 234, edge device, tablet, mobile device, human interface module (HIM), on-prem/remote/cloud server, etc.), or a combination of computing devices, within the OT environment of FIG. 1.

Referring now to FIG. 4, the computing device 26 may parse the PLC ladder logic code 300 to generate the causal graph 310 and the subgraph 312. In OT environments, PLCs (e.g., controller 12) may be programmed to control devices using ladder logic, in which logical relationships between inputs and outputs are represented as contacts and coils in a relay circuit, respectively.

In the illustrated embodiment of FIG. 4, the PLC ladder logic code 300 includes a ladder logic latch with hold in logic, with Input A 302 (a normally opened contact) and Input B 304 (a normally closed contact) on the same rung as Output Y 306 (a coil), and Output Y 308 (a normally opened contact) branched (i.e., in parallel with Input A 302). Accordingly, the logic expression of the PLC ladder logic code 300 may be expressed as: *if* Input A 302 or Output Y 308 is true, *and* Input B 304 is false, *then* Output Y is true. The PLC code 300 may program a PLC (e.g., controller 12) controlling an industrial device, such as motor 14, within the OT environment. For example, Output Y 306 may represent the motor 14. When Output Y 306 is true, the motor 14 may be on and when Output Y 306 is false, the motor 14 may be off. Input A 302 may represent a physical button, switch, or the like that when actuated (i.e., pressed, flipped, etc.) causes the motor 14 (i.e., the industrial device represented by Output Y) to turn on or start operation, and Input B 304 may represent a physical button, switch, or the like, that when actuated (i.e., pressed, flipped, etc.) causes the motor 14 (i.e., the industrial device represented as Output Y) to turn off or stop operation. The PLC code 300 includes Output Y 308 as a branched normally opened contact (i.e., an input) so that when Output Y 308 is true, Output Y 306 is true if Input B is false, even if Input A is false. Accordingly, the PLC (e.g., controller 12) programmed with PLC ladder logic code 300 may control an industrial device (represented by Output Y) to maintain operations after an input device (represented by Input A 302) is actuated to trigger the operations, as long as an input device (represented by Input B 304) has not been actuated to stop the operations. Conversely, the PLC (e.g., controller 12) programmed with PLC ladder logic code 300 may control an industrial device (represented by Output Y) to maintain pausing operations after an input device (represented by Input B 304) is actuated to stop the operations, as long as an input device (represented by Input A 302) has not been actuated to restart the operations.

The computing device 26 may receive and parse the PLC code 300 to extract the causal relationships defined in the PLC code 300, as described above, in order to generate the causal graph 310. Specifically, the computing device 26 may parse the PLC code 300 to determine the relationships between the inputs and outputs of the system. The computing device 26 may generate a causal context tag for each input and output defined by the PLC code 300 by using simple node and edge attributes to capture the causal relationships. For example, each input and output defined in the PLC code 300 may be defined as a node, which may have edges defined by in and out vertices corresponding to the respective inputs and outputs the node is in contact with. Accordingly, the illustrated causal graph 310 may represent Input A 302 as a node with an arrow connecting to Input B 304, Input B 304 as a node with an arrow from Input A 302 and an arrow connecting to Output Y 306, Output Y 306 as a node with an arrow from Input B 304 and an arrow connecting to Output Y 308. Additionally, the computing device 26 may identify Output Y 308 as an unobserved modifier to Input A 302 and generate the causal subgraph 312, which represents Output Y 308 as a node with an arrow connecting to a node representing Input A 302. The subgraph 312 captures the effect of unobserved modifiers, such as randomness, throughout the system as changes to Input A 302 may affect and cause corresponding changes to Input B 304, Output Y 306, and Output Y 308, as seen in causal graph 310. Accordingly, the computing device 26 may generate causal graphs that account for hidden variables and randomness experienced within OT environments.

Further, by extracting causal relationships directly from design sources, such as PLC code, the computing device 26 may generate living causal graphs that dynamically update (e.g., update in real time or near real time as design sources are updated) to reflect changes in the respective design sources. For example, a device (e.g., motor) controlled according to PLC code 300 may be modified to require two inputs to start operations (e.g., a second start button, switch, etc.) and an additional normally opened contact Input X may be added to PLC code 300 between Input A 302 and Input B 304, parallel to Output Y 308, such that logical expression may be expressed as: *if* Input A 302 *and* Input X is true *or* Output Y 308 is true, *and* Input B 304 is false, *then* Output Y is true. Accordingly, the computing device 26 may update causal graph 310 to include Input X in between the nodes for Input A 302 and Input B 304 without requiring additional user input (e.g., a command to generate a new causal graph for the device or system controlled according to PLC code 300). Additionally, by extracting causal relationships directly from design sources, the computing device 26 may perform offline data analysis on-premise (e.g., on an edge device disposed at the edge), online data analysis in the cloud, or some combination thereof.

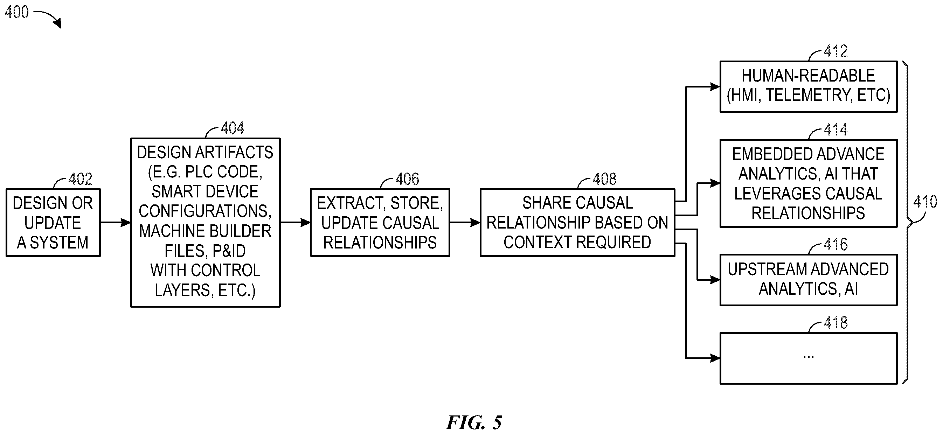

FIG. 5 illustrates a block diagram of a method 400 for identifying causal relationships in context to generate causal graphs, such as those illustrated in FIG. 4, in accordance with embodiments described herein. Although the following description of the method 400 is described in a particular order, which represents a particular embodiment, it should be noted that the method 400 may be performed in any suitable order. Moreover, although the following description of method 400 is described as being performed by the computing device 26, it should be noted that the method 400 may be performed by any suitable computing device (e.g., operator device 234), or a combination of computing devices, within the OT environment.

Referring now to FIG. 5, at block 402, a user may design and/or update an industrial automation system. As discussed above in regards to FIG. 1, the computing device 26 may receive inputs from the user defining and/or updating an industrial automation project using a native application running on the computing device 26 or using a website accessible via a browser application, a software application, or the like. At block 404, the user may define and/or update the industrial automation project by generating and/or updating one or more design artifacts such as PLC code, Smart device configurations, machine builder files, piping and instrumentation diagrams (P&IDs) with control layers, and the like. Specifically, the user may generate and/or update design artifacts by writing or editing code, interacting with a visual programming interface, inputting or selecting values via a graphical user interface, or providing some other inputs to the computing device 26. The user may use licensed software and/or subscription services to create, analyze, and otherwise develop the industrial automation project.

Industrial automation systems may be deterministic, meaning the logic controlling the system and defining the input/output relationships between industrial automation devices is embedded in the design source code (i.e., design artifacts). At block 406, the computing device 26 may extract, store, and update causal relationships by parsing and/or compiling the one or more design artifacts (e.g., PLC code, Smart device configurations, machine builder files, P&IDs, etc.). For example, the computing device 26 may parse PLC code defining the industrial automation project to determine the relationships between the inputs and outputs of the system, as seen in FIG. 4. The computing device 26 may generate a causal context tag for each input and output defined by the one or more design artifacts by using simple node and edge attributes to capture the causal relationships. The computing device 26 may store each tag or variable extracted from the one or more design artifacts in one or more causal symbol tables stored in a database. The one or more causal symbol tables may organize the tags or variables according to the associated design artifact, industrial automation system (when the industrial automation project is associated with multiple interdependent systems), production lines or portions of production lines, associated industrial devices, and the like (or a combination thereof). The database may be stored locally on the internal memory 22 of the control system 20 and remotely on the cloud server 30. Accordingly, the computing device 26 may perform online and offline data analysis at the on-premise edge and in the cloud. The computing device 26 may further parse the design sources at predetermined intervals of time (e.g. every minute, hour, day, etc.) to identify changes in the causal relationships. Additionally, or alternatively, the user may request the computing device to further parse the design sources to identify changes in the causal relationships (e.g., the user may input a command to the computing device to further parse the design sources directly after editing design source code). Accordingly, the computing device may update the tags or variables stored in the one or more causal symbol tables in response to updates or changes to the design sources.

At block 408, the user may share causal relationships based on different contexts required shown in blocks 410. The computing device 26 may generate causal graphs (e.g., causal graph 310 and subgraph 312) using the tags and/or variables stored in the one or more causal symbol tables to represent complex causal relationships in a human-readable context 412. For example, the computing device 26 may share causal graphs via a human-machine interface (HMI), telemetry, and the like. The computing device 26 may generate causal graphs and/or share the one or more causal symbol tables to utilize the complex causal relationships in an embedded advanced analytics context 414 as well as an upstream advanced analytics context 416. For example, the computing device 26 may share the causal graphs with an on-premise (e.g., stored in the memory and executed by the processor of a local controller) machine-learning algorithm, large language model, artificial intelligence, and the like, in order to leverage the complex causal relationships locally. Additionally, the computing device 26 may generate causal graphs and/or share the one or more causal symbol tables to utilize the complex causal relationships in an upstream advanced analytics context 416. For example, the computing device 26 may share the causal graphs with an off-premise (e.g., stored in the cloud and executed by one or more remote computing devices) machine-learning algorithm, large language model, artificial intelligence, and the like, in order to leverage the complex causal relationships globally. The computing device may also share the causal relationships based on any suitable additional context 418. Across the different contexts 310, the causal relationships may be utilized in a number of applications, such as root cause analysis, hazard analysis, failure mode and effect analysis (FMEA), process control and optimization, quality control and optimization, prescriptive analytics, etc.

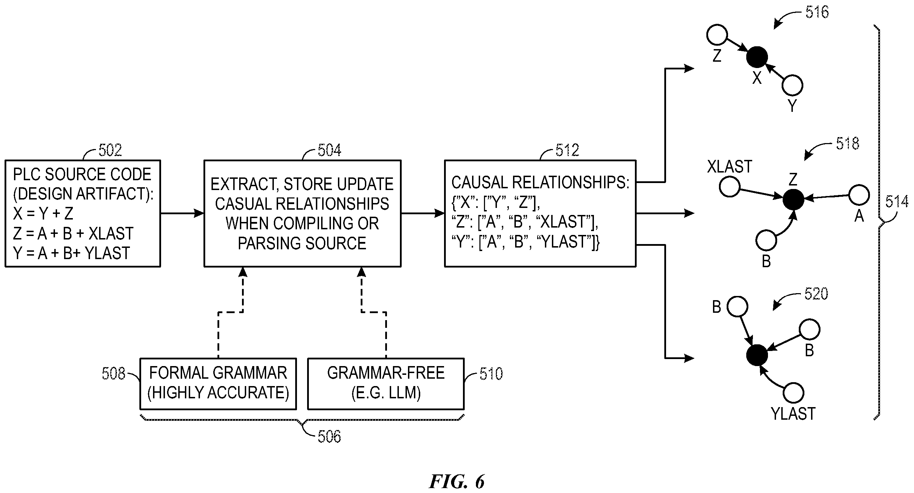

FIG. 6 illustrates a block diagram of extracting causal relationships from a design artifact using the method of FIG. 5. In the illustrated embodiment, the design artifact is a simplified PLC source code. While not illustrated, it should be noted that design artifact may be a more complex PLC source code, Smart device configuration, machine builder file, P&ID, and the like.

Referring now to FIG. 6, at block 502, simplified PLC source code is identified as the relevant design artifact. In certain embodiments, a user may manually identify the relevant design artifact to extract causal relationships from. In further embodiments, the computing device 26 may automatically identify one or more relevant design artifacts to extract causal relationships from when applying the method 400 to a respective industrial automation program. In the illustrated example, the simplified PLC source code includes three equations that may define the behaviors and relationships between three interdependent variables x, y, and z. The variables x, y, and z may define operating characteristics of three different industrial devices that are communicatively coupled to perform an industrial automation process (e.g., sensors, conveyors, drives, motors, etc.). The variables x, y, z may also define operating characteristics of components (e.g., control valves, hydraulic cylinders, etc.) of an assembly, and/or may define three different operating characteristics of one industrial device (e.g., a controller). The variables a and b may be coefficients that contribute to the overall operating characteristics corresponding to variables y and z (e.g., operating parameters corresponding to user defined settings). The variables xlast and ylast may correspond to the previous values of x and y respectively (i.e., the resultant x and y values from the last time the code was run).

At block 504, a user may extract, store, and update causal relationships using computing device 26, or any other suitable computing device(s), while compiling or parsing the simplified PLC source code of block 502 (i.e., the design source). This may be achieved using the methods described in blocks 506. Specifically, at block 508, the computing device 26 may run a software application or series of software applications to formally parse the grammar of the simplified PLC source code (e.g., parser generator(s), lexer generator(s), listener(s), etc., capable of analyzing structured text, binary files, etc.). Additionally, or alternatively, at block 510, the computing device 26 may use a large language model to extract causal relationships from the simplified PLC source code. As discussed above, the computing device 26 may generate a causal context tag for each input and output extracted from the simplified PLC source code (i.e., x, y, z, a, b, xlast, ylast) by using simple node and edge attributes to capture the causal relationships. The computing device 26 may store each tag or variable extracted from the simplified PLC source code in one or more causal symbol tables stored in a database. Additionally, the computing device 26 may update the tags or variables stored in the one or more causal symbol tables in response to updates or changes to the simplified PLC source code. The computing device 26 may further parse the simplified PLC source code at time intervals defined by the user (e.g. every minute, hour, day, etc.) to identify updates and changes to the causal relationships. The user may also manually request the computing device to further parse the simplified PLC source code to identify changes in the causal relationships (e.g., the user may input a command to the computing device to further parse the simplified PLC source code directly after editing the code).

At block 512, the computing device 26 may use the causal context tags with simple node and edge attributes to generate causal subgraphs for x, y, and z, shown in blocks 514. At block 516, the subgraph for x depicts the causal relationships between x, y, and z, extracted from the first line of the simplified PLC source code from block 502. Specifically, block 516 illustrates that x (i.e., an operating characteristic of an industrial device) may be influenced by y and z (e.g., two other operating characteristics of the industrial device, two operating characteristics of interdependent industrial devices, etc.). At block 518, the subgraph for z depicts the causal relationships between z, a, b, and xlast, extracted from the second line of the simplified PLC source code from block 502. Specifically, block 518 illustrates that z may be influenced by a and b (i.e., operating parameters contributing to the operating characteristics associated with z and y), as well as xlast (i.e., the last value of x output by running the PLC source code). At block 520, the subgraph for y depicts the causal relationships between y, a, b, and ylast, extracted from the third line of the simplified PLC source code from block 502. Specifically, block 520 illustrates that y may be influenced by a and b (i.e., operating parameters contributing to the operating characteristics associated with z and y), as well as ylast (i.e., the last value of y output by running the PLC source code).

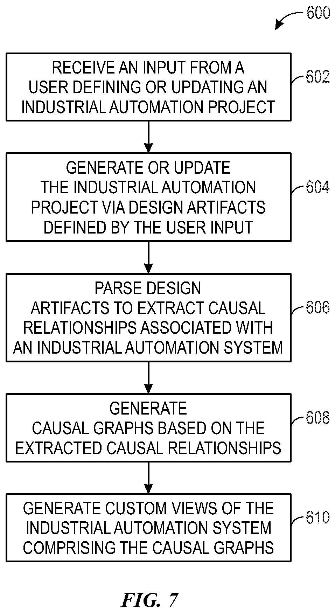

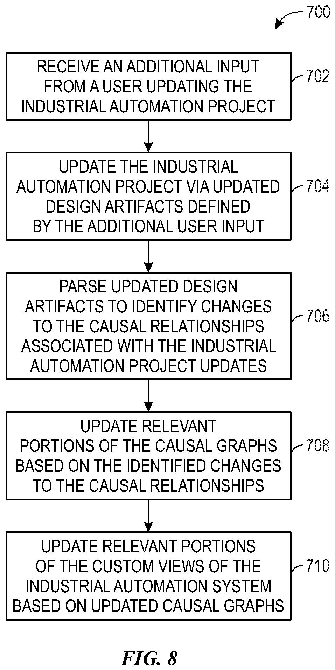

While not shown in FIG. 6, the computing device 26 may also generate a global causal graph (i.e., a causal graph depicting the relationships shown in the subgraphs of blocks 514). For example, the global causal graph may resemble the subgraph for x shown in block 516, with the nodes for z and y additionally connected to their respective inputs (e.g., a, b, xlast, ylast), as seen in blocks 518 and 520. The global causal graphs and causal subgraphs generated by the computing device 26 may be organized into customized views to display the causal relationships to the user(s). A process of generating and updating customized views based on the causal graphs generated according to the method 400 of FIG. 5 is discussed in detail below in regards to FIGS. 7 and 8.

FIG. 7 illustrates a process 600 of generating custom views an industrial automation system using causal relationships captured according to the method of FIG. 5. The process 600 may be used with new industrial automation projects as well as pre-existing industrial automation projects. At block 602, the computing device 26 may receive an input from a user defining or updating an industrial automation project. The computing device 26 may receive the input via a native application, a website accessible via a browser application, a software application, and the like. The input may correspond to generating or updating one or more design artifacts such as PLC code, Smart device configurations, machine builder files, piping and instrumentation diagrams (P&IDs) with control layers, and the like. In other embodiments, rather than receiving inputs, the process 600 may receive one or more code files to parse. At block 604, the computing device 26 may generate or update the industrial automation project using the one or more design artifacts defined or updated based on the input. For example, the computing device 26 may generate and/or update the industrial automation project using design artifacts defined or updated based on user-written code, user interactions with a visual programming interface, user-defined or user-selected values from a graphical user interface, or other user inputs.

At block 606, the computing device 26 may parse the design artifacts to extract causal relationships. The logic controlling the industrial automation system and defining the input/output relationships between industrial automation devices is embedded in the design source code (i.e., design artifacts) of the industrial automation project. Accordingly, the computing device may parse and/or compile PLC code, Smart device configurations, machine builder files, P&IDs, and/or any other suitable design source code associated with the industrial automation project to extract the causal relationships. For example, the computing device 26 may parse PLC code defining the industrial automation project to determine the relationships between the inputs and outputs of the system, as seen in FIG. 4. The computing device 26 may generate a causal context tag for each input and output defined by the one or more design artifacts by using simple node and edge attributes to capture the causal relationships. The computing device 26 may store each tag or variable extracted from the one or more design artifacts in one or more causal symbol tables stored in a database. The one or more causal symbol tables may organize the tags or variables according to the associated design artifact, industrial automation system (when the industrial automation project is associated with multiple interdependent systems), production lines, portions of production lines, associated industrial devices, and the like (or a combination thereof). The database may be stored locally on the internal memory 22 of the control system 20 and remotely on the cloud server 30. Accordingly, the computing device 26 may perform online and offline data analysis at the on-premise edge and in the cloud.

While the computing device 26 is described as the same computing device used to author or update the industrial automation project, in certain embodiments, the computing device 26 may not be the authoring tool. In such embodiments, the computing device 26 may receive the design artifacts from the authoring tool(s), and may parse the design artifacts associated with the industrial automation project at time intervals defined by the user (e.g., every minute, hour, day, etc.) to identify the causal relationships, as well as, updates and changes in the causal relationships. The user may also manually request the computing device 26 to parse the design artifacts to identify the causal relationships and updates/changes to the causal relationships (e.g., the user may input a command to the computing device to parse the design artifact directly after the design artifact is received from the authoring tool and/or directly after user edits).

At block 608, the computing device 26 may generate causal graphs based on the extracted causal relationships. The computing device 26 may use the causal context tags with simple node and edge attributes stored in the database to generate causal graphs, in which each interdependent variable of the industrial automation project is represented by a node and is connected via a directional edge(s) to the variable(s) it has causal relationships with. For example, a causal graph of an industrial automation project including one industrial automation device driven by a motor may represent the industrial automation device as a first node, with an edge from a second node representing the motor. The second node representing the motor may have two directional edges from two nodes representing input motor frequency and input motor voltage, as the input motor frequency and input motor voltage may determine the operating characteristic(s) of the motor. The computing device 26 may generate a global causal graph showing the industrial device node, the motor node, the motor frequency node, and the motor voltage node, with the industrial device node connected to the motor node, and the motor node connected to the motor frequency node and the motor voltage node. The computing device 26 may also generate causal subgraphs for the industrial device and for the motor. The industrial device subgraph may include the industrial device node connected to the motor node, excluding the motor frequency node and the motor voltage node. The motor subgraph may include the motor node connected to the motor frequency node and the motor voltage node, excluding the industrial device node. Thus, each causal subgraph may depict one output (e.g., the industrial device, the motor) with each of the inputs defining the output (e.g., the motor for the industrial device subgraph, the motor frequency and motor voltage for the motor subgraph).

At block 610, the computing device 26 may generate custom views of the industrial automation system to present to the user. The custom views may be displayed using a user-interface (e.g., GUI) of the computing device 26, and/or using a user-interface of any suitable computing device in communication with the computing device 26. The custom views may include DCS, fleet, and plant views. For example, if the computing device generated causal graphs for an industrial automation project associated with a controller within a distributed control system (DCS), the computing device may generate a DCS view presenting the causal graphs generated according to the industrial automation project as well as additional causal graphs from other industrial automation projects associated with the controller and other controllers in the DCS. Additionally, or alternatively, if the computing device generated causal graphs for an industrial automation project associated with an industrial device of a fleet of industrial devices, the computing device may generate a fleet view presenting the generated causal graphs along with additional causal graphs associated with other industrial devices in the fleet. Additionally, or alternatively, if the computing device generated causal graphs for an industrial automation project associated with a plant (e.g., industrial automation facility), the computing device may generate a plant view presenting the generated causal graphs along with additional causal graphs associated with other industrial devices in the plant.

The custom views may organize the causal graphs based on hierarchical relationships of interdependent industrial automation systems, hierarchical relationships of industrial devices within a single industrial automation system, and the like. For example, the custom views may reflect relative physical locations and relationships of associated industrial automation systems, industrial automation devices, etc. Additionally, based on predefined user preferences, the custom views may hide causal subgraphs and display all or a specific grouping of subgraphs upon request, thereby presenting simplified views that may provide additional data (e.g., subgraphs) upon request. Alternatively, the custom views may display all causal graphs and subgraphs, thereby presenting detailed views that may be simplified upon request (i.e., may hide some or all of the subgraphs). The user may supply inputs to modify or interact with a custom view. For example, the user may select filtering options to hide one or more portions of the custom view. The filtering options may indicate a request to only show or emphasize the causal graphs associated with a specific design artifact, industrial automation system, production line, portion of a production line, industrial device, etc. In response to the selected filtering options, the user-interface displaying the custom view may highlight the associated causal graphs, gray out causal graphs that are not associated with the selected filtering options (i.e., unassociated causal graphs), and/or temporarily hide the unassociated causal graphs.

The custom views may include living causal graphs that update to reflect in real-time changes to the logic controlling the industrial automation system (e.g., updates and/or edits to design artifacts). FIG. 8 illustrates a process 700 of updating custom views. At block 702, the computing device 26 may receive an additional input from a user updating an industrial automation project. The computing device 26 may receive the additional input via a native application, a website accessible via a browser application, a software application, and the like. The additional input may correspond to updating one or more design artifacts such as PLC code, Smart device configurations, machine builder files, piping and instrumentation diagrams (P&IDs) with control layers, and the like. At block 704, the computing device 26 may deploy the updated industrial automation project using the one or more design artifacts updated based on the additional input. For example, the computing device 26 may deploy updated industrial automation projects using design artifacts updated based on user-written code, user interactions with a visual programming interface, user-defined or user-selected values from a graphical user interface, or other user inputs.

At block 706, the computing device 26 may parse the design artifacts to identify one or more changes to previously extracted causal relationships caused by the update(s) to the industrial automation project. The computing device 26 may parse and/or compile PLC code, Smart device configurations, machine builder files, P&IDs, and/or any other suitable design source code associated with the updated industrial automation project to identify changes in the extracted causal relationships. For example, the computing device 26 may parse updated PLC code defining the industrial automation project to determine the changes in the relationships between the inputs and outputs of the system. The computing device 26 may generate an updated causal context tag for each input and output defined by the one or more design artifacts by using simple node and edge attributes to capture the causal relationships. The computing device 26 may compare each updated tag or variable to each tag or variable stored in the causal symbol table(s) stored in the database, and may replace the stored tag or variable with the updated tag or variable if a change is detected. Accordingly, the computing device 26 may store only current causal tags and variables, without using storage or computing power on out of date tags and variables. Alternatively, the computing device 26 may store each updated tag or variable in an updated causal symbol table(s) in addition to previously stored causal symbol table(s) to allow for analysis of changes in causal relationships over time.

While the computing device 26 is described as the same computing device used to author updates, in certain embodiments, the computing device 26 may not be the authoring tool associated with the industrial automation project updates. In such embodiments, the computing device 26 may receive the design artifacts from the authoring tool(s) and may parse the design artifacts associated with the industrial automation project at time intervals defined by the user (e.g., every minute, hour, day, etc.) to identify updates and changes to the causal relationships. The user may also manually request the computing device 26 to parse the design artifacts to identify changes in the causal relationships (e.g., the user may input a command to the computing device to parse the design artifact directly after user edits).

At block 708, the computing device 26 may update relevant portions of causal graphs based on the identified changes in the extracted causal relationships. The computing device 26 may use the updated causal context tags stored in the database to update the causal graphs. For example, if an industrial automation project including an industrial automation device driven by a DC motor is updated to replace the DC motor with a universal motor (i.e., a motor capable of operating on both AC and DC), the causal graphs would update to replace the DC motor node with an AC/DC motor node, and a motor frequency node would be added as an input to the AC/DC motor node. The industrial device node and the motor voltage node would remain unedited. Accordingly, the updated global causal graph would show the industrial device node connected to the AC/DC motor, and the AC/DC node connected to the voltage node and the frequency node, rather than show the industrial device node connected to a DC motor node, and the DC motor node connected to the voltage node. The subgraphs would be updated accordingly, with the industrial device subgraph including the industrial device node connected to the AC/DC motor node, and the AC/DC motor subgraph including the AC/DC motor node connected to the voltage node and the frequency node.

At block 710, the computing device 26 may update relevant portions of the custom views of the industrial automation system based on the updated causal graphs. For example, if the causal graphs associated with the industrial automation project discussed above are part of a plant view of an industrial automation system, then only the portions of the plant view related to the industrial device and motor are updated to replace the DC motor node with the AC/DC motor node and to add the motor frequency node as an input to the AC/DC motor node. Accordingly, the computing device 26 may not need to spend time or processing power generating a completely new plant view. The updated custom views may be displayed using a user-interface of the computing device 26, and/or using a user-interface of any suitable computing device in communication with the computing device 26. The user-interface displaying the custom views may display a notification indicating the updates. For example, the user-interface may highlight or bold the updated nodes and edge connections, and may indicate which nodes and edge connections they replaced. The updated custom views may be leveraged to detect security breaches and unauthorized control modifications. Specifically, the user may detect anomalies and unexpected modifications in the causal graphs, which may reflect security breaches and unauthorized control modifications in the industrial automation system.

The disclosed techniques are directed towards providing causal graph relationships for complex industrial systems by extracting and deriving causal relationships directly from design sources defining the operations of industrial devices within the respective industrial systems. The design sources may include control code, project code files, device configurations, machine builder files, programmable logic controller (PLC) ladder logic, intelligent device control logic, and the like. The causal graph relationships may be used to provide a custom system view to the user, which may be leveraged for performing root cause analysis and other functions. The approach may be applied to hierarchical, interdependent systems and may provide DCS, plant, and fleet views to the user. The custom views may include living causal graphs that update to reflect in real-time changes to the logic controlling the industrial automation system. Accordingly, the disclosed method differs from traditional formal and static analysis of PLC code, as it allows for dynamic updates, as well as, online and offline data analysis at the on-premise edge and in the cloud. The user may use detected anomalies and modifications in the causal graphs to detect security breaches and unauthorized control modifications.

By incorporating the processes described above, the present disclosure may detect security breaches and unauthorized control modifications in industrial automation systems. Specifically, the disclosed techniques leverage the deterministic nature of industrial automation systems to parse design artifacts such as PLC code, P&ID digital designs, digital twin models, Intelligent Device code, etc. and generate causal graph data. By extracting the causal relationships directly from the engineering artifacts, this method may provide concise descriptions of the causal relationships, as only relevant causal data is illustrated and presented to the user. Further, the causal graph data may be used to provide custom system views to the user, which may be leveraged for performing root cause analysis and other functions. The approach may be applied to hierarchical, interdependent systems and may provide DCS, plant, and fleet views to the user. The custom views may include living causal graphs that update to reflect in real-time changes to the logic controlling the industrial automation system. Accordingly, the disclosed method differs from traditional formal and static analysis of design artifacts (e.g., PLC code), as it allows for dynamic updates, as well as, online and offline data analysis at the on-premise edge and in the cloud. The user may use detected anomalies and modifications in the causal graphs to detect security breaches and unauthorized control modifications. Thus, the disclosed system and method for generating causal graphs from causal relationships embedded in design sources may be used to detect security breaches and unauthorized control modifications in industrial automation systems, and may provide benefits over traditional PLC code analysis processes.

While only certain features have been illustrated and described herein, many modifications and changes will occur to those skilled in the art. It is, therefore, to be understood that the appended claims are intended to cover all such modifications and changes as fall within the true spirit of the disclosure.

The techniques presented and claimed herein are referenced and applied to material objects and concrete examples of a practical nature that demonstrably improve the present technical field and, as such, are not abstract, intangible or purely theoretical. Further, if any claims appended to the end of this specification contain one or more elements designated as "means for (perform)ing (a function)..." or "step for (perform)ing (a function)...", it is intended that such elements are to be interpreted under 35 U.S.C. 112(f). However, for any claims containing elements designated in any other manner, it is intended that such elements are not to be interpreted under 35 U.S.C. 112(f).

## Claims

1. A system comprising:
processing circuitry; and
a memory accessible by the processing circuitry, the memory storing instructions that, when executed by the processing circuitry, cause the processing circuitry to perform operations comprising:
receiving a first input indicative of a selection of a design artifact from a plurality of design artifacts stored in the memory, wherein the design artifact defines an industrial automation project associated with an industrial automation system, and wherein the industrial automation system comprises one or more industrial automation components configured to perform an industrial automation process based on the industrial automation project;
parsing the design artifact in response to receiving the first input;
identifying one or more causal relationships between the one or more industrial automation components based on the parsed design artifact;
storing data indicative of the identified causal relationships in a database;
generating one or more causal graphs based on the stored data, wherein the causal graphs comprise a visual representation of input/output relationships between the one or more industrial automation components;
receiving a second input indicative of a request to generate a custom view of the industrial automation system;
generating the custom view of the industrial automation system in response to the second input, wherein the custom view comprises the one or more causal graphs; and
presenting the custom view within a graphical user interface (GUI) via an electronic display.

2. The system of claim 1, at least one of:
wherein the design artifact comprises a portion of PLC code, a piping and instrumentation diagram (P&ID) digital design, a digital twin model, a portion of Intelligent Device code, or any combination thereof;
wherein the one or more causal graphs represent the one or more industrial automation components as nodes and the input/output relationships between the one or more industrial automation components as edges between the nodes;
wherein the custom view comprises the causal graphs organized according to hierarchical relationships, relative physical positions of the one or more industrial automation components, or both; and
wherein the second input comprises a selection of a type of custom view, and wherein the type corresponds to a DCS view, a plant view, a fleet view, or any combination thereof.

3. The system of claim 1 or 2, wherein the operations comprise:
receiving a third input indicative of a change to the design artifact;
parsing the design artifact in response to receiving the third input;
identifying one or more changes in the one or more causal relationships between the one or more industrial automation components based on the parsed design artifact, wherein the one or more changes are associated with the change to the design artifact;
updating the data indicative of the causal relationships stored in the database to reflect the identified changes;
updating a portion of the one or more causal graphs based on the updated data to reflect the identified changes;
updating the custom view of the industrial automation system, wherein the update comprises replacing the portion of the one or more causal graphs with the updated portion of the one or more updated causal graphs; and
presenting the updated custom view within the GUI.

4. The system of claim 3, wherein an unexpected update to the custom view indicates a security breach, an unauthorized control modification within the industrial automation system, or both.

5. The system of one of claims 1 to 4, wherein the database is stored locally in the memory and remotely in a cloud server.

6. A method, comprising:
receiving a first input indicative of a selection of a design artifact from a plurality of design artifacts associated with an industrial automation system comprising one or more industrial automation devices, wherein each design artifact of the plurality design artifacts defines an industrial automation project configured to control the industrial automation devices to perform an industrial automation process;
parsing the selected design artifact in response to receiving the first input;
identifying input/output relationships between the one or more industrial automation devices based on the parsed design artifact;
generating one or more causal graphs based on the identified input/output relationships, wherein the causal graphs comprise a visual representation of the identified input/output relationships between the one or more industrial automation devices;
receiving a second input indicative of a request to generate a custom view of the industrial automation system;
generating the custom view of the industrial automation system in response to the second input, wherein the custom view comprises the one or more causal graphs; and
presenting the custom view within a graphical user interface (GUI).

7. The method of claim 6, wherein each design artifact of the plurality of design artifacts comprises a portion of PLC code, a piping and instrumentation diagram (P&ID) digital design, a digital twin model, a portion of Intelligent Device code, or any combination thereof.

8. The method of claim 6 or 7, at least one of:
wherein the one or more causal graphs represent the one or more industrial automation devices as nodes and the input/output relationships between the one or more industrial automation devices as edges between the nodes;
wherein the custom view comprises the causal graphs organized according to hierarchical relationships, relative physical positions of the one or more industrial automation devices, or both; and
wherein the second input comprises a selection of a type of custom view, and wherein the type corresponds to a DCS view, a plant view, a fleet view, or any combination thereof.

9. The method of one of claims 6 to 8, comprising:
receiving a third input indicative of a change to the design artifact;
parsing the design artifact in response to receiving the third input;
identifying one or more changes in the input/output relationships between the one or more industrial automation devices based on the parsed design artifact, wherein the one or more changes are associated with the change to the design artifact;
identifying a portion of the one or more causal graphs containing input/output relationships that do not reflect the change to the design artifact;
updating the portion of the one or more causal graphs based on the identified changes in the input/output relationships;
updating the custom view of the industrial automation system, wherein the update comprises replacing the portion of the one or more causal graphs with the updated portion of the one or more causal graphs; and
presenting the updated custom view within the GUI.

10. The method of claim 9, comprising:
detecting an occurrence of an unexpected event during operation of the industrial automation system based on an unexpected update to the custom view; and
identifying a cause of the unexpected event based on the custom view.

11. A non-transitory, tangible, computer readable medium comprising instructions that, when executed by processing circuitry, causes the processing circuitry to perform operations comprising:
receiving a first input indicative of a selection of a design artifact from a plurality of design artifacts associated with an industrial automation system comprising one or more industrial automation devices, wherein each design artifact of the plurality design artifacts defines an industrial automation project configured to control the one or more industrial automation devices to perform an industrial automation process;
parsing the design artifact in response to receiving the first input;
identifying one or more causal relationships between the one or more industrial automation devices based on the parsed design artifact;
storing data indicative of the identified causal relationships in a database;
generating one or more causal graphs based on the stored data, wherein the causal graphs comprise a visual representation of input/output relationships between the one or more industrial automation devices;
receiving a second input indicative of a request to generate a custom view of the industrial automation system;
generating the custom view of the industrial automation system in response to the second input, wherein the custom view comprises the one or more causal graphs; and
presenting the custom view within a graphical user interface (GUI) via an electronic display.

12. The computer readable medium of claim 11, wherein the operations comprise:
receiving a third input indicative of a change to the design artifact;
parsing the design artifact in response to receiving the third input;
identifying one or more changes in the one or more causal relationships between the one or more industrial devices, wherein the one or more changes are associated with the change to the design artifact;
updating the stored data to reflect the identified changes in the one or more causal relationships;
identifying a portion of the one or more causal graphs that do not reflect the changes in the one or more causal relationships;
updating the portion of the one or more causal graphs based on the identified changes in the causal relationships;
updating the custom view of the industrial automation system, wherein the update comprises replacing the portion of the one or more causal graphs with the updated portion of the one or more causal graphs; and
presenting the updated custom view within the GUI.

13. The computer readable medium of claim 11 or 12, wherein each design artifact of the plurality of design artifacts comprises a portion of PLC code, a piping and instrumentation diagram (P&ID) digital design, a digital twin model, a portion of Intelligent Device code, or any combination thereof.

14. The computer readable medium of one of claims 11 to 13, wherein the one or more causal graphs represent the one or more industrial automation devices as nodes and the input/output relationships between the one or more industrial automation devices as edges between the nodes.

15. The computer readable medium of one of claims 11 to 14, wherein the second input comprises a selection of a type of custom view, and wherein the type corresponds to one of a DCS view, a plant view, a fleet view, or any combination thereof.
